# EUROPÄISCHE PATENTANMELDUNG

(11) **EP 0 834 745 A2**
(43) Veröffentlichungstag der Anmeldung: **08.04.1998**
(21) Anmeldenummer: 97810658.1
(22) Anmeldetag: 15.09.1997
(51) Int. Cl.: G01R 15/18

(54) **Rogowskispule**

(30) Priorität: 04.10.1996 DE 19640981
(71) Anmelder: Asea Brown Boveri AG, 5401 Baden (CH)
(72) Erfinder: Bosco, Antonio, 4806 Wikon (CH); Seidel, Manfred, 5442 Fislisbach (CH); Kaczkowski, Andrzej, Dr., 5303 Würenlingen (CH)
(74) Vertreter: Kaiser, Helmut

(57) **Zusammenfassung**

Die Rogowskispule (1) ist mit einer auf einen Wicklungsträger aus einem Isoliermaterial aufgebrachten Wicklung (2) versehen. Sie weist eine zentrale Achse (4) und eine von dem Wicklungsträger umfasste Öffnung (5), die von der zentralen Achse (4) durchdrungen ist, auf. Eine besonders homogene Wicklung (2) und damit verbunden eine sehr genaue Strommessung wird dadurch erreicht, dass eine der zentralen Achse (4) zugewandte Oberfläche des Wicklungsträgers mit am Umfang verteilten, sich in Richtung der zentralen Achse (4) erstreckenden und die Wicklung (2) in Wicklungssegmente (9) aufteilenden ersten Anschlägen (7) versehen ist. Der Abstand zwischen jeweils zwei der ersten Anschläge (7) ist dabei stets ein ganzzahliges Vielfaches des Durchmessers (D) des die Wicklung (2) bildenden Drahtes.

## Beschreibung

### TECHNISCHES GEBIET

Bei der Erfindung wird ausgegangen von einer Rogowskispule gemäss dem Oberbegriff des Anspruchs 1.

### STAND DER TECHNIK

Eine Rogowskispule und ihre Anwendung ist beispielsweise in der Offenlegungsschrift DE-3 544 508 A1 beschrieben. Die Rogowskispule wird in dieser Schrift in einem Strommessgerät verwendet, welches in metallgekapselten gasisolierten Schaltanlagen eingesetzt werden kann. Wenn, wie bei der Energieverteilung, genaue Strommessungen verlangt werden, so muss diese Rogowskispule mit einer besonders homogenen Wicklung versehen werden. Bei der beschriebenen Ausführungsform der Rogowskispule wird jedoch auf diese Problematik nicht eingegangen.

### KURZE DARSTELLUNG DER ERFINDUNG

Der Erfindung, wie sie in den unabhängigen Patentansprüchen definiert ist, liegt die Aufgabe zugrunde, eine Rogowskispule anzugeben, bei welcher mit einfachen Mitteln eine besonders homogene Wicklung erreicht wird.

Die erfindungsgemässe Rogowskispule ist für besonders genaue Strommessungen geeignet. Die Segmentierung der Wicklung erlaubt es, etwaige kleine Ungenauigkeiten, die beim Wickeln stets auftreten können, mit grosser Sicherheit zu kompensieren. Wenn für die Wicklungen der Rogowskispule besonders dünner Draht verwendet wird, so kann es vorkommen, dass die Dicke der Drahtisolation schwankt. Durch die konsequente Segmentierung der Wicklung wird der Einfluss dieser Drahtdickeschwankungen reduziert, insbesondere auch dann, wenn die Anzahl der Windungen pro Wicklungssegment klein gehalten wird. Windungszahlen von drei bis acht Windungen pro Segment haben sich als besonders zweckmässig erwiesen. Besonders homogene Wicklungen von Rogowskispulen erreicht man, wenn diese Wicklungen einlagig ausgeführt werden.

Die für die Segmentierung der Wicklung vorgesehen Anschläge können, wenn sie nach innen oder aussen vorstehend ausgebildet sind, zusätzlich für die genaue Positionierung der Rogowskispule an ihrem Einbauort genutzt werden.

Weitere Ausführungsbeispiele der Erfindung und die damit erzielbaren Vorteile werden nachfolgend anhand der Zeichnung, welche lediglich einen möglichen Ausführungsweg darstellt, näher erläutert.

### KURZE BESCHREIBUNG DER ZEICHNUNG

Es zeigen:

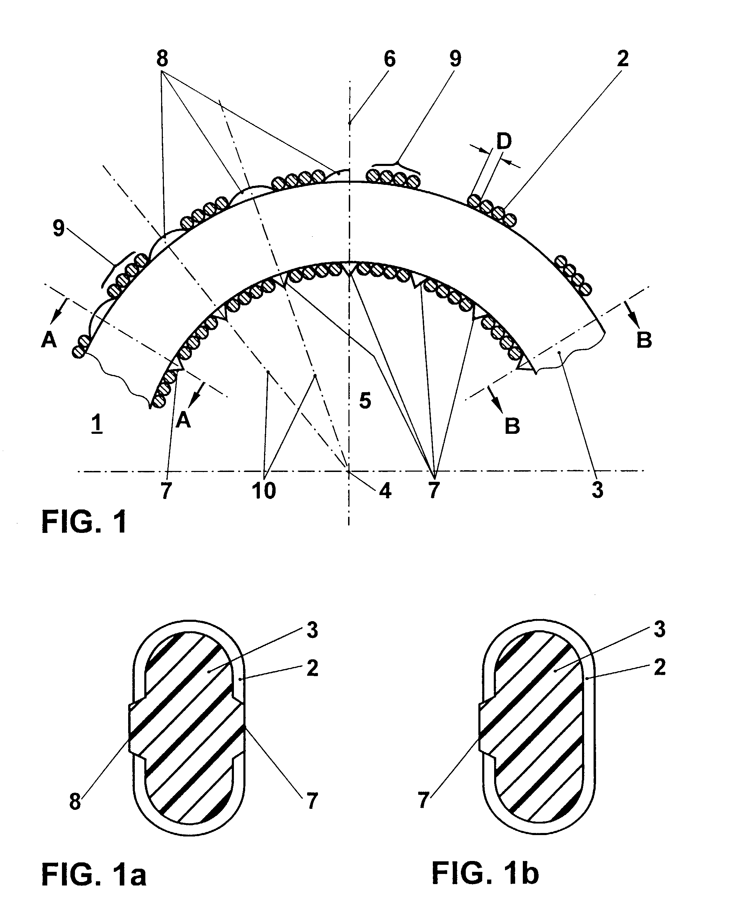

Fig.1 einen schematisch dargestellten Ausschnitt aus einer Rogowskispule, wobei in der linken Hälfte der Figur eine erste Ausführungsform und in der rechten Hälfte eine zweite Ausführungsform der Rogowskispule gezeigt wird,
Fig.1a einen Teilschnitt, in der Fig.1 mit A-A bezeichnet, durch die erste Ausführungsform der Rogowskispule, und
Fig.1b einen Teilschnitt, in der Fig.1 mit B-B bezeichnet, durch die zweite Ausführungsform der Rogowskispule.

Bei allen Figuren sind gleich wirkende Elemente mit gleichen Bezugszeichen versehen. Alle für das unmittelbare Verständnis der Erfindung nicht erforderlichen Elemente sind nicht dargestellt.

### WEGE ZUR AUSFÜHRUNG DER ERFINDUNG

Die Fig.1 zeigt einen schematisch dargestellten Ausschnitt aus einer Rogowskispule 1. Diese Rogowskispule 1 weist eine Wicklung 2 aus einem isolierten Metalldraht mit einem kreisförmigen Querschnitt auf, die gleichmässig um einen aus einem Isoliermaterial gefertigten, in der Regel gegossenen, Torus 3 gewickelt ist. Der Metalldraht weist einen Durchmesser D auf. Der Torus 3 ist kreisförmig um eine zentrale Achse 4 aufgebaut, welche sich senkrecht zur Zeichnungsebene der Fig.1 erstreckt. Der Torus 3 weist hier einen im wesentlichen rechteckigen Querschnitt auf, wobei die Schmalseiten des Rechtecks abgerundet sind, wie dies aus den Figuren 1a und 1b ersichtlich ist. Es sind auch, je nach vorgesehener Verwendung der Rogowskispule 1, andere Querschnittsformen für den Torus 3 vorstellbar, insbesondere auch kreisförmige oder ellipsenförmige Querschnitte.

Der Torus 3 der Rogowskispule 1 umschliesst eine zylindrisch ausgebildete Öffnung 5, welche sich in Richtung der zentralen Achse 4 erstreckt. Durch diese Öffnung 5, und zwar in der Regel durch das Zentrum derselben, wird der nicht dargestellte Leiter geführt. Der in diesem Leiter fliessende Strom wird mit Hilfe der Rogowskispule 1 gemessen. Senkrecht zur zentralen Achse 4 ist eine Trennungslinie 6 gezeichnet. Links von dieser Trennungslinie 6 ist eine erste Ausführungsform der Rogowskispule 1 dargestellt. Die Fig.la zeigt einen Teilschnitt, der in der Fig.1 mit A-A bezeichnet ist, durch diese erste Ausführungsform der Rogowskispule. Auf der der zentralen Achse 4 zugewandten Oberfläche des Torus 3 sind in regelmässigen, auf den Durchmesser D des Drahtes der Wicklung 2 abgestimmten Abständen, Anschläge 7 angeformt, die sich in Richtung der zentralen Achse 4 erstrecken. Die Abstände sind in ganzzahligen Vielfachen des Durchmessers D bemessen. Die Anschläge 7 weisen hier beispielsweise einen dreieckigen Querschnitt auf. Die einzelnen Anschläge 7 sind so beabstandet, dass der Zwischenraum zwischen ihnen durch eine einlagige Wicklung 2 gerade aufgefüllt wird, wobei sich dabei die Isolationen der Drähte der einzelnen Windungen gerade berühren. Zwischen jeweils zwei Anschlägen 7 hat immer die gleiche Anzahl Windungen, die ein Wicklungssegment 9 bilden, Platz. Die Anschläge 7 erstrecken sich jedoch nicht über die gesamte Länge des Torus 3. Als Anzahl Windungen für so ein durch die Anschläge 7 begrenztes Wicklungssegment 9 hat sich eine Zahl von 3 bis 8 Windungen als vorteilhaft herausgestellt. Bei dieser vergleichsweise kleinen Anzahl von Windungen reichen die durch die Anschläge 7 verursachten kleinen Zwischenräume in der Wicklung 2 aus, um etwaige, beispielsweise durch unterschiedliche Dicke der Isolation des Wicklungsdrahts hervorgerufene, Unterschiede des Drahtdurchmessers D aufzunehmen.

Bei dieser ersten Ausführungsform sind auch auf der der Öffnung 5 abgewandten Oberfläche des Torus 3 Anschläge 8 angeformt, die sich ebenfalls axial über einen Teil der Länge des Torus 3 erstrecken und die ballig ausgeformt sind. Zwischen jeweils zwei Anschlägen 8 hat immer die gleiche Anzahl Windungen, die das Wicklungssegment 9 bilden, Platz. Die Anschläge 7 und 8 sind einander paarweise jeweils so zugeordnet, dass ihre Mitten auf einer radial von der zentralen Achse 4 ausgehenden Achse 10 liegen.

Es ist auch vorstellbar, dass bei einer weiteren Ausführungsform der Rogowskispule 1 die Anschläge 7 weggelassen werden, sodass lediglich die Anschläge 8 für die Aufteilung der Wicklung 2 in gleiche Wicklungssegmente 9 verfügbar sind.

Rechts von dieser Trennungslinie 6 ist eine zweite, etwas vereinfachte Ausführungsform der Rogowskispule 1 dargestellt. Bei dieser Ausführungsform sind lediglich die bereits beschriebenen, gleichmässig beabstandeten Anschläge 7 vorgesehen. Die Fig.lb zeigt einen Teilschnitt, der in der Fig.1 mit B-B bezeichnet ist, durch diese zweite Ausführungsform der Rogowskispule. Auf der der zentralen Achse 4 zugewandten Oberfläche des Torus 3 sind in regelmässigen, auf den Durchmesser D des Drahtes der Wicklung 2 abgestimmten Abständen, Anschläge 7 angeformt, die sich in Richtung der zentralen Achse 4 erstrecken. Die Abstände sind in ganzzahligen Vielfachen des Durchmessers D bemessen, sodass auch hier jeweils ein Wicklungssegment 9 zwischen den Anschlägen 7 Platz hat.

Durch diese konsequente Aufteilung der Wicklung 2 in einzelne Wicklungssegmente 9, die, bedingt durch die sie mechanisch trennenden Anschläge 7 und 8, alle die gleiche Windungszahl haben, wird eine besonders homogene Verteilung der Windungen auf dem Torus 3 erreicht. Diese besonders homogen ausgeführte Wicklung 2 ermöglicht eine besonders genaue Bestimmung des durch den umschlossenen Leiter fliessenden Stroms. Es ist nunmehr möglich, mit Hilfe dieser besonders homogen bewickelten Rogowskispule 1 Stromwandler herzustellen, welche die Genauigkeitsanforderungen der Wandlerklasse 0,1 erfüllen, d.h. diese Stromwandler messen den Strom mit weniger als 0,1% Fehler.

Der Einbau der Rogowskispule 1 wird erleichtert, wenn die Anschläge 7 etwas über den Durchmesser der Wicklung 2 in Richtung der zentralen Achse 4 vorstehen, da diese Spule auf einen entsprechend dimensionierten Absatz des Gehäuses aufgeschoben werden kann, sodass die Spule konzentrisch zum Leiter angeordnet ist. Die Rogowskispule 1 muss dann lediglich auf eine der bekannten Arten gegen ein Abrutschen von diesem Absatz gesichert werden. Diese Montageart erleichtert den Einbau der Rogowskispule 1 sehr, da ein aufwendiges Justieren wegfällt. Eine andere Einbauvariante ergibt sich, wenn die Anschläge 8 über die Wicklung 2, radial von der zentralen Achse 4 weg, vorstehen. Diese Spule kann dann in eine sie umfassende angepasste Aussparung des umschliessenden Gehäuses so eingeschoben werden, dass die Anschläge 8 die Zentrierung der Rogowskispule 1 übernehmen. Auch bei dieser Montageart ist eine aufwendige Justierung der Rogowskispule 1 nicht notwendig.

### BEZEICHNUNGSLISTE

- 1: Rogowskispule
- 2: Wicklung
- 3: Torus
- 4: zentrale Achse
- 5: Öffnung
- 6: Trennungslinie
- 7, 8: Anschläge
- 9: Wicklungssegment
- 10: Achse
- D: Durchmesser des Wicklungsdrahts

## Patentansprüche

1. Rogowskispule (1) mit einer auf einen Wicklungsträger aus einem Isoliermaterial aufgebrachten Wicklung (2), mit einer zentralen Achse (4), mit einer von dem Wicklungsträger umfassten Öffnung (5), die von der zentralen Achse (4) durchdrungen wird, dadurch gekennzeichnet,
- dass eine der zentralen Achse (4) zugewandte Oberfläche des Wicklungsträgers mit am Umfang verteilten, sich in Richtung der zentralen Achse (4) erstreckenden und die Wicklung (2) in Wicklungssegmente (9) aufteilenden ersten Anschlägen (7) versehen ist, und
- dass der Abstand zwischen jeweils zwei der ersten Anschläge (7) stets ein ganzzahliges Vielfaches des Durchmessers (D) des die Wicklung (2) bildenden Drahtes ist.

2. Rogowskispule (1) mit einer auf einen Wicklungsträger aus einem Isoliermaterial aufgebrachten Wicklung (2), mit einer zentralen Achse (4), mit einer von dem Wicklungsträger umfassten Öffnung (5), die von der zentralen Achse (4) durchdrungen wird, dadurch gekennzeichnet,
- dass eine der zentralen Achse (4) abgewandte Oberfläche des Wicklungsträgers mit am Umfang verteilten, sich in Richtung der zentralen Achse (4) erstreckenden und die Wicklung (2) in Wicklungssegmente (9) aufteilenden zweiten Anschlägen (8) versehen ist, und
- dass der Abstand zwischen jeweils zwei der zweiten Anschläge (8) stets ein ganzzahliges Vielfaches des Durchmessers (D) des die Wicklung (2) bildenden Drahtes ist.

3. Rogowskispule nach Anspruch 1, dadurch gekennzeichnet,
- dass eine der zentralen Achse (4) abgewandte Oberfläche des Wicklungsträgers mit am Umfang verteilten, sich in Richtung der zentralen Achse (4) erstreckenden und die Wicklung (2) in Wicklungssegmente (9) aufteilenden zweiten Anschlägen (8) versehen ist,
- dass der Abstand zwischen jeweils zwei der zweiten Anschläge (8) gleich ist, wie der Abstand zwischen zwei ersten Anschlägen (7), und
- dass jeweils der erste Anschlag (7) und der zweite Anschlag (8) einander so zugeordnet sind, dass ihre Mitten auf einer radial von der zentralen Achse (4) ausgehenden Achse (10) liegen.

4. Rogowskispule nach einem der Ansprüche 1 bis 3, dadurch gekennzeichnet,
- dass alle Wicklungssegmente (9) die gleiche Anzahl Windungen aufweisen.

5. Rogowskispule nach einem der Ansprüche 1 bis 4, dadurch gekennzeichnet,
- dass die Wicklung (2) einlagig ausgeführt ist .

6. Rogowskispule nach einem der Ansprüche 1 bis 6, dadurch gekennzeichnet,
- dass Anzahl Windungen pro Wicklungssegment (9) vorzugsweise im Bereich von drei bis acht liegt.

7. Rogowskispule nach Anspruch 1, dadurch gekennzeichnet,
- dass die ersten Anschläge (7) über die Wicklung (2) hinaus in Richtung auf die zentrale Achse (4) vorstehen.

8. Rogowskispule nach einem der Ansprüche 2 oder 3, dadurch gekennzeichnet,
- dass die zweiten Anschläge (8) über die Wicklung (2) hinaus radial von der zentralen Achse (4) weg vorstehen.

9. Rogowskispule nach einem der Ansprüche 1 bis 8, dadurch gekennzeichnet,
- dass der Wicklungsträger als Torus (3) ausgebildet ist.
